# EUROPEAN PATENT APPLICATION

(11) **EP 1 365 456 A2**
(43) Date of publication of application: **26.11.2003**
(21) Application number: 03253217.8
(22) Date of filing: 22.05.2003
(51) Int. Cl.: H01L 39/22

(54) **Josephson junction**

(30) Priority: 22.05.2002 JP 2002147491
(71) Applicant: National Institute of Advanced Industrial Science and Technology, Tsukuba-shi, Ibaraki (JP)
(72) Inventor: Yamamori, Hirotake, c/o National Inst. of Advanced, Umezono 1-chome, Tsukuba-Shi, Ibaraki (JP); Shoji, Akira, c/o National Institute of Advanced, Umezono 1-chome, Tsukuba-Shi, Ibaraki (JP)
(74) Representative: Cross, Rupert Edward Blount

(57) **Abstract**

A Josephson junction comprises electrodes (1,3) and intermediate layer (2) provided between the electrodes wherein the electrodes and the intermediate layer are made of the same material but have different conductive states, a superconductor and a normal-state conductor which are produced by changing a composition ratio of niobium of a niobium nitride thin film, and nitrogen, by controlling the quantity of nitrogen gas at the time of thin film creation.

## Description

### Technical Field of the Invention

The present invention relates to a circuit using a Josephson junction in which niobium nitride (NbN) is used as electrode material, especially to S/N/S (superconductivity / usual state conductivity / superconductivity) type superconductivity junction array integrated circuit capable of operating at high temperature (about 10K degree).

### Description of Related Art

It is required to accumulate many Josephson junctions on one chip to obtain large output voltage by the junction array for programmable Josephson voltage standard. In order to accumulate many Josephson junctions on the limited chip area such Josephson junctions may be laminated in a vertical direction.

However, since the speed of etching depends on materials used, when material of a superconductivity electrode and material of a usual state conduction electrode (an intermediate layer) differ, the end of junctions does not become flat.

This may cause faulty short circuit between junctions.

### Summary of the Invention

It is an object of the present invention to provide a Josephson junction in which output voltage is increased.

It is another object of the present invention to provide a Josephson junction in which the same material is used for such electrode(s) and the intermediate layer(s).

A Josephson junction whose intermediate electrode is made of amorphous niobium nitride has been proposed. Since the superconductiveness of the electrode made of niobium nitride would deteriorate if high-quality polycrystalline niobium nitride is formed on amorphous material, it is difficult to form such a vertically laminated high-quality Josephson junction.

In vertically laminating electrodes and intermediate layer(s) etc. to form a Josephson junction made of a quality niobium nitride, amorphous material is not suitable for an intermediate electrode.

According to the present invention, since crystallinity is maintained between a lower electrode and intermediate layer, and between the intermediate layer and upper electrode, by using mono-crystal or polycrystal niobium nitride for the intermediate electrode as well as the electrodes, it is possible to vertically laminate the electrodes and the intermediate layer to form the quality Josephson junction.

Thus, the present invention provides a Josephson junction wherein at least one of electrodes and an intermediate layer are made of a single crystal or multi-crystal niobium nitride.

The Josephson junction may comprise two or more Josephson injunctions which are laminated.

The Josephson Junction may be applied to a digital-analog converter.

The digital-analog converter may be applied to a junction array for programmable Josephson voltage standard

The junction array for programmable Josephson voltage standard may be applied to a Josephson voltage generating apparatus

The Josephson voltage generating apparatus may be applied to a Josephson voltage standard apparatus.

The present invention also provides a Josephson junction comprising at least two electrodes, an intermediate layer provided between the at least two electrodes, wherein at least one of the at least two electrodes and the intermediate layer are made of a single crystal or multi-crystal niobium nitride.

### Description of the Drawings

The present inventions will now be described by way of example with reference to the following figures in which:
Fig. 1 is a diagram showing a structure of a Josephson junction; and
Fig. 2 is a diagram showing a structure of a multilayer type Josephson junction.

### Detailed Description of the Invention

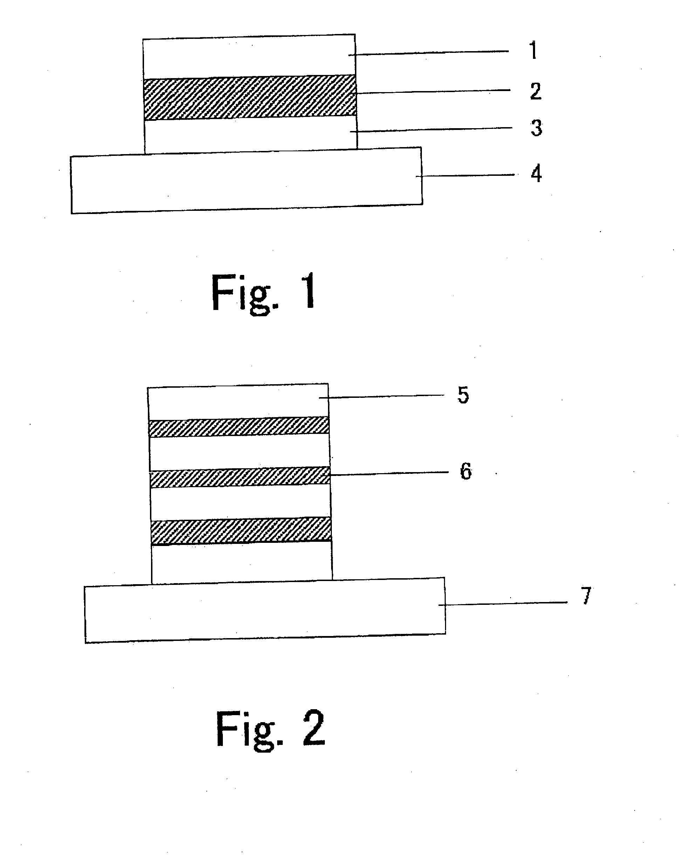

An embodiment of the present invention is described referring to Figs. 1 and 2 below.

As shown in Fig. 1, a Josephson junction comprises an electrode (superconductor) 1, an electrode (normal conductor) 2, and an electrode (superconductor) 3.

It is required for an intermediate electrode to be a normal conductor at an operating temperature (typically 4.2 K or 10K).

Niobium nitride becomes a superconductor or a normal state conductor (semiconductor), depending on the quantity of nitrogen atom contained in a thin film. When nitrogen gas partial pressure is 5% of the total gas pressure of argon gas and nitrogen gas, a niobium nitride thin film becomes a superconductor. And the niobium nitride becomes a normal conductor in the other conditions.

When the niobium nitride thin film is formed by sputtering, the niobium nitride of a superconductor and the niobium nitride of a normal conductor can be selectively produced by controlling partial pressure of nitrogen gas to argon gas, and such a Josephson junction can be realized by forming the electrode (superconductor) 1, the intermediate layer (normal conductor) 2, and the electrode (superconductor) 3 in order.

By repeating this process two or more times, it is possible to vertically laminate two or more Josephson junctions, as shown in Fig. 2.

Since the electric resistivity of the niobium nitride thin film changes if the nitrogen partial pressure is changed in producing the niobium nitride thin film of a normal conductor, it is possible to control IcRn product (product of critical current and normal conductor resistance) which is one of the important parameters of the Josephson junction.

It is possible to vertically laminate multi-layers, maintaining a good crystal state by using the same material for the intermediate layer and the electrodes, and it possible to vertically laminate two or more high-quality Josephson junctions.

If much more Josephson junctions can be laminated, since it is possible to increase output voltage of the digital-analog converter for the programmable Josephson voltage standard, and to make a chip area small. Therefore, it leads also to a cost cut.

Further, a digital-analog converter may be applied to a junction array for programmable Josephson voltage standard.

Furthermore, the junction array for programmable Josephson voltage standard may be applied to a Josephson voltage generating apparatus.

Although only some exemplary embodiments of this invention have been described in detail above, those skilled in the art will readily appreciated that many modifications are possible in the exemplary embodiments without materially departing from the novel teachings and advantages of this invention. Accordingly, all such modifications are intended to be included within the scope of this invention.

## Claims

1. A Josephson junction wherein at least one of electrodes and an intermediate layer are made of a single crystal or multi-crystal niobium nitride.

2. The Josephson junction according to claim 1, wherein the Josephson junction comprises two or more Josephson injunctions which are laminated.

3. A digital-analog converter wherein the Josephson Junction according to claim 1 or 2 is used.

4. A junction array for programmable Josephson voltage standard wherein the digital-analog converter according to claim 3 is used.

5. A Josephson voltage generating apparatus wherein the junction array for programmable Josephson voltage standard according to claim 4 is used.

6. A Josephson voltage standard apparatus wherein the Josephson voltage generating apparatus according to claim 5 is used.

7. A Josephson junction comprising:
at least two electrodes;
an intermediate layer provided between the at least two electrodes;
wherein at least one of the at least two electrodes and the intermediate layer are made of a single crystal or multi-crystal niobium nitride.
